# FASCICULE DE BREVET EUROPEEN

(11) **EP 2 842 179 B1**
(45) Date de publication et mention de la délivrance du brevet: **08.06.2016**
(21) Numéro de dépôt: 13723015.7
(22) Date de dépôt: 23.04.2013
(51) Int. Cl.: H01L 51/48

(54) **PROCÉDÉ DE DÉPÔT DE NANOPARTICULES SUR UN SUBSTRAT D'OXYDE MÉTALLIQUE NANOSTRUCTURÉ**
VERFAHREN ZUR ABSCHEIDUNG VON NANOPARTIKELN AUF EINEM NANOSTRUKTURIERTEN METALLOXIDSUBSTRAT
PROCESS FOR DEPOSITING NANOPARTICLES ON A NANO-STRUCTURED METAL-OXIDE SUBSTRATE

(30) Priorité: 26.04.2012 FR 1253825
(43) Date de publication de la demande: 04.03.2015
(73) Titulaire: Commissariat à l'Énergie Atomique et aux Énergies Alternatives, 75015 Paris (FR)
(72) Inventeur: ALDAKOV, Dimitry, F-38000 Grenoble (FR); IVANOVA-HRISTOVA, Valentina, F-38000 Grenoble (FR); REISS, Peter, F-38120 Saint Egrève (FR); SANCHEZ, Sylvia, F-38410 Vaulnaveys Le Haut (FR)
(74) Mandataire: Decobert, Jean-Pascal
(86) Numéro de dépôt international: PCT/EP2013/058365
(87) Numéro de publication internationale: WO 2013/160285

(56) Documents cités:
- US-A1- 2009 159 120
- US-A1- 2009 211 634
- ARDALAN P ET AL: "Phosphonate self-assembled monolayers as organic linkers in solid-state quantum dot sensetized solar cells", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20 juin 2010 (2010-06-20), pages 951-954, XP031784336, ISBN: 978-1-4244-5890-5
- CRAIG L. PERKINS: "Molecular Anchors for Self-Assembled Monolayers on ZnO: A Direct Comparison of the Thiol and Phosphonic Acid Moieties", JOURNAL OF PHYSICAL CHEMISTRY C, vol. 113, no. 42, 22 octobre 2009 (2009-10-22), pages 18276-18286, XP055049004, ISSN: 1932-7447, DOI: 10.1021/jp906013r
- SUSANNE KRÜGER ET AL: "Study of the Attachment of Linker Molecules and Their Effects on the Charge Carrier Transfer at Lead Sulfide Nanoparticle Sensitized ZnO Substrates", JOURNAL OF PHYSICAL CHEMISTRY C, vol. 115, no. 26, 7 juillet 2011 (2011-07-07), pages 13047-13055, XP055048979, ISSN: 1932-7447, DOI: 10.1021/jp200935x
- TSUNG-WEI ZENG ET AL: "Effects of bifunctional linker on the optical properties of ZnO nanocolumn-linker-CdSe quantum dots heterostructure", JOURNAL OF COLLOID AND INTERFACE SCIENCE, ACADEMIC PRESS, NEW YORK, NY, US, vol. 358, no. 2, 1 mars 2011 (2011-03-01), pages 323-328, XP028197831, ISSN: 0021-9797, DOI: 10.1016/J.JCIS.2011.03.002 [extrait le 2011-03-08]
- SARATHY K V ET AL: "SUPERLATTICES OF METAL AND METAL-SEMICONDUCTOR QUANTUM DOTS OBTAINED BY LAYER-BY-LAYER DEPOSITION OF NANOPARTICLE ARRAYS", JOURNAL OF PHYSICAL CHEMISTRY. B, MATERIALS, SURFACES, INTERFACES AND BIOPHYSICAL, WASHINGTON, DC, US, vol. 103, 1 janvier 1999 (1999-01-01), pages 399-401, XP000858368, ISSN: 1089-5647, DOI: 10.1021/JP983836L

## Description

### Domaine Technique

La présente invention concerne un procédé de dépôt de nanoparticules sur un oxyde métallique nanostructuré (OMNS) d'oxyde de zinc.

Les oxydes métalliques nanostructurés (OMNS) peuvent être utilisés en tant qu'électrodes pour des dispositifs (opto-)électroniques. Ils offrent une approche versatile et performante pour l'assemblage « bottom-up ». De plus, ils ont un fort potentiel pour l'intégration de l'électronique organique avec celle à base de matériaux inorganiques grâce à la facilité de leur synthèse, leur très bonne cristallinité et leur haute conductivité qui leur confèrent de bonnes propriétés d'accepteurs d'électrons. Beaucoup d'applications nécessitent de recouvrir ces nanostructures par des nanocristaux (NCx) ou plus généralement des nanoparticules (NPs), notamment pour la fabrication de cellules solaires sensibilisées avec des boîtes quantiques (QDSSC - en anglais, Quantum Dot Sensitized Solar Cells), des photo-détecteurs, des diodes électroluminescentes (LEDs), des photoémetteurs directionnels ou des mémoires. Pour ces applications, les nanocristaux servent par exemple d'absorbeurs ou d'émetteurs de lumière, ou bien de capacitances. La méthode de dépôt des nanocristaux sur les nanostructures a un effet crucial sur le comportement du dispositif final, son efficacité et son coût.

La présente invention concerne le traitement de la surface d'un OMNS d'oxyde de zinc qui rend le dépôt des NPs rapide et efficace.

### Etat de la Technique

Le dépôt des NPs sur les OMNS peut être effectué par plusieurs méthodes :
- Croissance des NPs directement sur les oxydes par la procédure de dépôt chimique en solution (« *chemical bath deposition* », CBD),
- Adsorption et réaction des couches ioniques successives (« *successive ion layer adsorption and reaction* », SILAR).

Le dépôt des NPs par la méthode CBD est relativement simple et consiste en un trempage des substrats dans la solution qui contient tous les précurseurs des NPs sous forme de sels. Cette fabrication est lente avec peu de contrôle sur la taille, la distribution de la taille et l'état de surface des NPs.

Le SILAR représente une modification du CBD et consiste en des trempages consécutifs des OMNS dans les solutions des précurseurs cationiques et anioniques. Cette méthode est plus efficace que le CBD sur le plan du choix de précurseurs et un peu meilleur pour le contrôle des NPs mais en général il souffre également des désavantages énumérés plus haut.

En synthétisant les NPs *ex situ,* on peut éviter ces problèmes. Dans le cas de physisorption - la méthode de fabrication de dispositifs actuellement la plus populaire - l'électrode nanostructurée est imprégnée par une solution des NPs pré-synthétisés. Dans ce cas il est difficile de contrôler la densité et l'épaisseur des particules à la surface de l'électrode nanostructurée. En particulier, la couverture de surface est souvent faible et des inhomogénéités de dépôt sont couramment observées selon la morphologie des nanostructures d'oxydes métalliques utilisées. L'assemblage des NPs par cette méthode dépend fortement des conditions de dépôt et de l'état de surface des OMNS.

Aujourd'hui le meilleur contrôle du dépôt des NPs sur les OMNS est obtenu en utilisant des agents de couplage bifonctionnels [Watson, D. F. J. Phys. Chem. Lett. 2010, 1, 2299-2309.]. Cette approche permet a *priori* de contrôler parfaitement la taille, la forme et la composition des NPs car ils sont fabriqués *ex situ.* Le principe de la méthode est le suivant : un groupe chimique de l'agent de couplage se greffe à la surface des nanoparticules qui permet leur accroche aux OMNS par un autre groupe de l'agent de couplage. Ce sont les NPs qui sont fonctionnalisées avec l'agent de couplage bifonctionnel, suivi par leur assemblage à la surface des OMNS. Cet échange des ligands à la surface des NPs génère généralement des défauts de surface qui peuvent agir comme états pièges pour des porteurs de charge et ainsi dégrader la performance d'un dispositif intégrant l'OMNS fabriqué. Un autre désavantage de l'échange de ligands est le fait qu'il peut diminuer la stabilité colloïdale des NPs et induire leur précipitation. Un autre problème pendant le dépôt des NPs sur les OMNS consiste à assurer la couverture la plus homogène possible pour l'utilisation la plus efficace d'excitons ou de porteurs de charge. Un dernier problème qui se pose souvent concerne les modalités techniques de dépôt. Les dépôts des NPs exigent souvent des équipements onéreux et/ou sophistiqués où le temps de dépôt est élevé ce qui complique la fabrication des dispositifs.

La publication Tsung-Wei Zeng et al intitulée « Effects of bifunctional linker on the optical properties of ZnO nanocolumn-linker-CdSe Quantum dots heterostructure » et publiée au Journal of Coloid and Interface Science (358-2011-323-328) propose une méthode de liaison entre une nanocolonne, par exemple en oxyde de zinc (ZnO) et des nanoparticules du type quantum dots. Selon ce document, une liaison est d'abord créée entre la nanocolonne et un agent de liaison. Ensuite, les nanoparticules sont couplées à l'agent de liaison. L'oxyde de zinc présente des avantages pour certaines applications du fait de la mobilité électronique et le temps de vie des électrons qui sont élevés, en comparaison, par exemple avec le dioxyde de titane (TiO2). Cependant, l'oxyde de zinc est aussi fragile et présente de ce fait des obstacles dans son utilisation sous forme de nanostructures. Il existe clairement un besoin pour améliorer l'emploi de l'oxyde de zinc comme matériau de base d'OMNS.

Il est recherché un moyen de lever tout ou partie des inconvénients cités ci-dessus.

### Exposé de l'invention

L'invention propose un procédé de dépôt de nanoparticules sur un substrat d'oxyde métallique nanostructuré (OMNS) d'oxyde de zinc qui comprend des étapes de :
a) fonctionnalisation du substrat d'OMNS par un agent de couplage bi-fonctionnel portant une première fonction étant une fonction phosphonique et formant une liaison avec l'OMNS, et une deuxième fonction destinée à former une liaison avec une nanoparticule ; et
b) greffage des nanoparticules par une liaison à la deuxième fonction de l'agent de couplage.

La fonctionnalisation de l'oxyde métallique nanostructuré (OMNS) par l'agent de couplage avant le greffage des nanoparticules (NPs) permet d'éviter l'étape de l'échange des ligands qui peut i) détériorer la stabilité colloïdale des NPs et induire leur précipitation, ii) générer des états pièges pour des porteurs de charge à la surface des NPs.

La dispersion en taille, la forme, la composition et l'état de la surface des nanoparticules sont contrôlés du fait de leur synthèse *ex situ.* Le choix d'un acide phosphonique comme première fonction de l'agent de couplage pour former une liaison avec l'oxyde métallique nanostructuré (OMNS) améliore l'attachement de l'agent de couplage à l'oxyde métallique nanostructuré (OMNS).

Le matériau utilisé comme oxyde métallique nanostructuré est l'oxyde de zinc (ZnO). Il faut noter que le ZnO est réputé très fragile et difficile à employer sous forme de nanostructures compte tenu de sa structure chimique. Et il est aussi facilement endommagé (corrodé, gravé et éventuellement dissous) par des solutions dont l'acidité ou la basicité est trop élevée. Cependant cet état de fait, il a été constaté, de manière surprenante, par l'invention, que l'emploi de l'acide phosphonique comme agent de couplage avec un OMNS d'oxyde de zinc donnait de très bons résultats et ce malgré la très forte acidité de cet acide. Ce résultat est d'autant plus inattendu que, selon le procédé de l'invention, l'acide phosphonique sert à la fonctionnalisation de l'oxyde de zinc avant le greffage de nanoparticules, ce qui place l'acide phosphonique dans des conditions de concentration qui seraient jugées normalement comme des plus défavorables pour obtenir des résultats satisfaisants c'est çà dire sans destruction du substrat d'OMNS. Ainsi, on peut obtenir des couplages de grande efficacité par l'acide phosphonique employé directement sur l'OMNS pour la fonctionnalisation de ce dernier, alors même que des acides ayant une acidité moindre tels que l'acide carboxylique produisent un endommagement de l'OMNS d'oxyde de zinc.

De plus, l'agent de couplage bifonctionnel avec une fonction phosphonique est compatible avec la surface nanostructurée de l'oxyde métallique grâce à leur mode de greffage bi- ou tridentate via des atomes d'oxygène.

### Exposé détaillé des modes de réalisation particuliers

Avant d'entrer dans le détail de modes de réalisation de l'invention, notamment en référence aux dessins, on indique des variantes préférées cumulatives ou alternatives mais non limitatives du procédé telles que :
- les étapes a) et b) sont effectuées par voie humide ;
- les NPs sont synthétisés de manière indépendante ;
- l'étape a) comprend le trempage de l'OMNS d'oxyde de zinc dans une solution d'agent de couplage bifonctionnel ;
- le trempage de l'OMNS d'oxyde de zinc de 10 secondes à 24 heures, de préférence de 1 minute à 6 heures, plus précisément une heure ;
- le trempage est précédé et suivi d'un rinçage avec un solvant par exemple à l'éthanol et d'un séchage par exemple sous flux argon ;
- l'étape b) comprend un trempage de l'OMNS d'oxyde de zinc fonctionnalisé obtenu à l'issue de l'étape a) dans une solution de nanoparticules ;
- le trempage de l'OMNS d'oxyde de zinc fonctionnalisé dure d'une minute à 72 heures, plus préférentiellement de 1 heure à 48 heures, de préférence 12 h
- le trempage de l'OMNS d'oxyde de zinc fonctionnalisé est suivi d'un rinçage avec un solvant par exemple au chloroforme et d'un séchage par exemple sous flux d'argon ;
- les étapes a) et b) sont effectuées à une température comprise entre 10 et 80°C, de préférence entre 18 et 25°C ;
- à l'étape a), l'agent de couplage bifonctionnel est en solution dans un solvant adapté, par exemple dans l'éthanol, diméthylsulfoxyde ou eau.
- à l'étape b) les NPs sont en solution dans un solvant adapté, par exemple du chloroforme, toluène, hexane ou heptane.
- l'agent de couplage comprend un espaceur entre la première fonction et la deuxième fonction ;
- l'espaceur comprend une chaîne carbonée de nature aliphatique saturée ou insaturée, linéaire ou ramifiée, ou de nature aromatique comportant de 2 à 36 atomes de carbone, l'espaceur peut contenir d'hétéroatomes tels que par exemple l'oxygène, le soufre ou le nitrogène ; l'espaceur peut être du type non conjugué;
- l'agent de couplage peut être choisi par exemple parmi l'acide mercaptoéthylphosphonique (MEPA) et l'acide mercaptoundécylphosphonique (MUPA) ;
- les nanoparticules sont des systèmes élémentaires, binaires, ternaires ou multinaires
- les nanoparticules sont de type composition homogène, de type alliage, de type coeur/coquille ou coeur/multiples coquilles ou peuvent avoir un gradient de composition.
- l'oxyde métallique nanostructuré est d'oxyde de zinc;
- la deuxième fonction est choisie parmi une fonction acide phosphinique, acide phosphonique, phosphine, oxyde de phosphine, acide carboxylique, amine, imidazole, pyridine, thiol, dithiol, carbodithioate, dithiocarbamate, xanthate, sulfonate, sulfate, sélénoate ou sélénate.
- le procédé peut comprendre postérieurement à l'étape b) les étapes successives de :
   - fonctionnalisation des NPs greffées à l'OMNS, par un deuxième agent de couplage bi-fonctionnel, configurés pour former une liaison avec les NPs liée à l'OMNS ; et
   - greffage des NPs par une liaison au deuxième agent de couplage.

L'empilement obtenu par le procédé inventif est tel que :
- l'agent de couplage comprend un espaceur entre la première fonction et la deuxième fonction ;
- l'espaceur comprend une chaîne carbonée de nature aliphatique saturée ou insaturée, linéaire ou ramifiée, ou de nature aromatique comportant de 2 à 36 atomes de carbone, l'espaceur peut contenir d'hétéroatomes tels que par exemple l'oxygène, le soufre ou le nitrogène ;
- l'agent de couplage peut être choisi par exemple parmi l'acide mercaptoéthylphosphonique (MEPA) et l'acide mercaptoundécylphosphonique (MUPA) ;
- les nanoparticules sont des systèmes élémentaires, binaires, ternaires ou multinaires
- les nanoparticules sont de type composition homogène, de type alliage, de type coeur/coquille ou coeur/multiples coquilles ou peuvent avoir un gradient de composition.
- l'oxyde métallique nanostructuré est d'oxyde de zinc;
- il comprend un deuxième agent de couplage bifonctionnel portant une première fonction et formant une liaison avec la nanoparticule liée à l'OMNS d'oxyde de zinc et une deuxième fonction formant une liaison avec une autre nanoparticule.
- il comprend de deux à trente couches de nanoparticules intercalées par des agents de couplage ; La nature des nanoparticules peut varier entre les différentes couches déposées.

Le procédé selon l'invention comprend avantageusement deux étapes, tout d'abord la fonctionnalisation d'un substrat d'oxyde métallique nanostructuré (OMNS) d'oxyde de zinc par l'agent de couplage bifonctionnel, puis le greffage de nanoparticules (NPs) sur l'oxyde métallique nanostructuré (OMNS) d'oxyde de zinc fonctionnalisé obtenu à l'étape précédente.

On entend par nanoparticule, un nano-objet tel que défini par la norme ISO TS/27687 dont les trois dimensions sont à l'échelle nanométrique.

Les nanoparticules peuvent être des nanocristaux.

Un oxyde nanostructuré est un oxyde dont l'état de surface comporte un relief dont une dimension est inférieure à 1 micromètre.

On entend par substrat d'oxyde métallique nanostructuré, un matériau destiné à recevoir divers composants et en particulier des nanoparticules. Le substrat d'oxyde métallique nanostructuré peut être par exemple une surface rugueuse, une surface supportant des nanoparticules ou nanofils d'oxyde métallique, ou une couche nanoporeuse. Le substrat peut coopérer avec un support (par exemple en silicium ou en verre ou en d'autres matériaux différant ou non de l'oxyde métallique employé pour la nanostructure proprement dite).

L'agent de couplage bifonctionnel comprend une première fonction étant une fonction phosphonique (-P(O)(OH)₂). La fonction phosphonique de l'agent de couplage bifonctionnel est destinée à former une liaison avec l'oxyde métallique nanostructuré. La liaison peut être une liaison covalente, hydrogène, ionique ou de coordination.

La liaison formée entre la fonction phosphonique et l'oxyde de zinc nanostructuré est une des plus fortes parmi toutes les fonctions de l'art antérieur. La fonction phosphonique a un mode de greffage bi ou tri-dentate. La liaison étant stable, la densité de l'agent de couplage sur l'oxyde de zinc nanostructuré est grande et le greffage des nanoparticules est également dense et uniforme.

Cette étape de fonctionnalisation est effectuée à des températures comprises entre 10° et 80°, plus précisément entre 15° et 50°, encore plus précisément entre 18 et 30°C, préférentiellement à température ambiante soit 25°C à pression atmosphérique. Il est avantageux de fonctionnaliser l'oxyde métallique nanostructuré sans nécessiter de températures élevées qui endommagent la nanostructure de l'oxyde de zinc

Selon l'invention, la fonctionnalisation de l'oxyde métallique nanostructuré d'oxyde de zinc est rapide. Préférentiellement, l'étape de fonctionnalisation a une durée de 10 secondes à 24 heures, plus précisément de 1 minute à 6 heures, préférentiellement de 1 heure.

Les deux étapes de fonctionnalisation et de greffage sont préférentiellement réalisées par voie humide.

On entend par voie humide, le trempage dans une solution, dépôt par la tournette ou par spray ou toute autre méthode dans laquelle l'agent de couplage bifonctionnel et les nanoparticules sont solubilisés dans un liquide. La fonctionnalisation de l'OMNS d'oxyde de zinc peut également s'effectuer en le mettant en contact avec une phase vapeur contenant l'agent de couplage bifonctionnel.

Le procédé selon l'invention ne nécessite pas d'installations ou de conditions complexes.

A titre d'exemple, l'oxyde métallique nanostructuré d'oxyde de zinc est immergé dans une solution contenant l'agent de couplage bifonctionnel.

L'agent de couplage bifonctionnel peut être en milieu aqueux ou organique. Préférentiellement, l'agent de couplage est en solution dans de l'éthanol, du diméthylsulfoxyde ou de l'eau de sorte à favoriser sa solubilité et sa réaction avec la surface de l'OMNS d'oxyde de zinc.

Selon un mode de réalisation, l'étape de fonctionnalisation de l'OMNS d'oxyde de zinc est précédée d'un rinçage de l'oxyde métallique nanostructuré, préférentiellement à l'eau suivi d'éthanol et d'un séchage préférentiellement sous flux d'argon. Ceci permet de retirer les éventuels contaminants et de contrôler l'oxydation de l'OMNS d'oxyde de zinc.

L'oxyde métallique nanostructuré d'oxyde de zinc est ensuite avantageusement exposé aux UV sous ozone, par exemple, pendant dix minutes pour enlever les contaminants résiduels organiques.

Suivant une préférence, l'étape de fonctionnalisation est suivie d'un rinçage, par exemple à l'éthanol et d'un séchage sous flux d'argon, de sorte à éliminer les agents de couplage bifonctionnels qui ne sont pas liés à l'oxyde métallique nanostructuré.

L'agent de couplage bifonctionnel est configuré pour se lier à l'oxyde métallique nanostructuré par une première fonction et aux nanoparticules (NPs) par une deuxième fonction.

La liaison avec l'OMNS d'oxyde de zinc se fait par une fonction phosphonique (-P(O)(OH)₂).

La liaison avec les NPs se fait par la deuxième fonction, choisie selon la nature des NPs, notamment choisie parmi acide phosphinique, acide phosphonique, phosphine, oxyde de phosphine, acide carboxylique, amine, imidazole, pyridine, thiol, dithiol, carbodithioate, dithiocarbamate, xanthate, sulfonate, sulfate, sélénoate ou sélénate. Préférentiellement, l'agent de couplage comprend un espaceur. L'espaceur est placé entre la première fonction et la deuxième fonction.

Selon une possibilité, l'espaceur comprend une chaîne carbonée de nature aliphatique saturée ou insaturée, linéaire ou ramifiée, ou de nature aromatique comportant de 2 à 36 atomes de carbone, dans les deux cas l'espaceur peut contenir d'hétéroatomes tels que par exemple l'oxygène, le soufre ou l'azote.

L'espaceur est configuré pour autoriser un couplage électronique entre les NPs et l'oxyde métallique nanostructuré. Le couplage électronique influence le transfert de charge entre les NPs et l'OMNS. Ce transfert doit être très efficace pour le bon fonctionnement des dispositifs tels que des cellules solaires ou des photo-détecteurs. Il dépend de la distance entre les NPs et les OMNS et donc de la longueur de l'espaceur ainsi que de sa nature chimique (aliphatique ou aromatique).

Préférentiellement, l'agent de couplage bifonctionnel est choisi parmi :

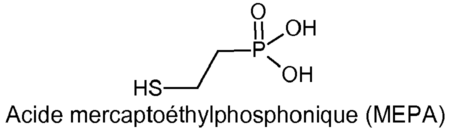

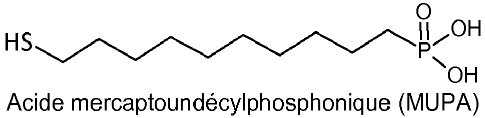

Selon l'invention, les nanoparticules sont avantageusement synthétisées lors d'une étape indépendante du présent procédé de dépôt.

Les NPs ont ainsi un état de surface mieux contrôlé, une taille et une distribution de la taille homogène.

A titre d'exemple, les nanoparticules sont des nanoparticules de Cuivre-Indium-Sélénium (CISe) ou Cuivre-Gallium-Indium-Selenium (CIGS) ou Cuivre-Indium-Soufre (CIS) ou Cuivre-Zinc-Indium-Soufre (CZIS) ou Cuivre-Fer-Soufre (CFS) ou Cuivre-Zinc-Etain-Sélénium (CZTSe) ou Cuivre-Zinc-Etain-Soufre (CZTS) ou Cadmium-Sélénium (CdSe) ou Cadmium-Soufre (CdS) ou Cadmium-Tellure (CdTe) ou Indium-Phosphore (InP) ou Indium-Arsène (InAs) ou Indium-Antimoine (InSb) ou de leurs alliage. Les nanoparticules peuvent présenter une structure homogène ou un gradient de composition. Elles peuvent être recouvertes par une ou plusieurs coquilles inorganiques par exemple CdSe/CdS, CulnS₂/ZnS, InP/ZnS.

L'étape de greffage des NPs permet de lier les NPs à la deuxième fonction de l'agent de couplage bifonctionnel lié à l'OMNS d'oxyde de zinc. L'étape de greffage comprend par exemple le trempage de l'OMNS d'oxyde de zinc fonctionnalisé par l'agent de couplage bifonctionnel dans une solution contenant les NPs.

L'étape de greffage est effectuée à des températures comprises entre 10° et 80°, plus précisément entre 15° et 40°, encore plus précisément entre 18 et 30°C, préférentiellement à température ambiante soit 25°C à pression atmosphérique.

A titre d'exemple, le trempage de l'OMNS d'oxyde de zinc fonctionnalisé a une durée d'une minute à 72 heures, plus préférentiellement de 1 heures à 48 heures, de préférence 12 h.

Après l'étape de greffage, l'OMNS d'oxyde de zinc fonctionnalisé et recouvert de NPs est préférentiellement rincé, par exemple au chloroforme et séché, par exemple, sous argon.

Selon une variante, le procédé comprend une étape ultérieure à l'étape de greffage des NPs permettant la formation d'autres couches ou épaisseurs de NPs. Il peut être préféré de prévoir une deuxième, voire une troisième couche de NPs sur l'OMNS d'oxyde de zinc pour augmenter par exemple l'absorption de la lumière dans une applicatior de type cellule solaire

Selon l'invention, l'OMNS d'oxyde de zinc comprend de une à trente couches de NPs ; la nature des nanoparticules peut varier entre les différentes couches déposées.

A cet effet, le procédé selon l'invention comprend une étape de fonctionnalisation de l'OMNS d'oxyde de zinc recouvert de la première couche de NPs. Cette première étape comprend une étape de liaison d'un deuxième agent de couplage bifonctionnel sur les NPs liées à l'OMNS d'oxyde de zinc. Ce deuxième agent de couplage bifonctionnel est destiné à relier par ces deux fonctions des NPs, préférentiellement situées sur des couches de rang distinct. Si les NPs sont identiques, les deux fonctions seront avantageusement identiques. A titre d'exemple on mentionne les dithiols par exemple. 1,2-éthanedithiol, 1,4-benzènedithiol, ou diamines par exemple 1,4-phénylènediamine. A l'inverse, si les NPs sont différentes, les deux fonctions seront différentes pour s'adapter au mieux aux NPs auxquelles elles doivent se lier.

Le deuxième agent de couplage bifonctionnel comprend un espaceur entre ces deux fonctions. L'espaceur peut être ou non identique à celui du premier agent de couplage liant l'OMNS et la première couche de NPs.

Après cette étape de fonctionnalisation, une étape de greffage permet la formation de liaisons entre le deuxième agent de couplage bifonctionnel et les NPs à greffer.

Ces étapes de fonctionnalisation et de greffage reprennent avantageusement les caractéristiques des étapes de fonctionnalisation et de greffage entre l'OMNS d'oxyde de zinc et les NPs de la première couche de NPs.

Un empilement obtenu par le procédé inventif comprenant un l'OMNS d'oxyde de zinc fonctionnalisé et greffé de NPs peut être utilisé pour la fabrication de cellules solaires de type QDSSC (quantum dot sensitized solar cell) ou de type ETA-SC (extremely thin absorber solar cell). Dans ces cas, on dépose un semi-conducteur de type p, par exemple du thiocyanate de cuivre, du spiro-OMeTAD, du PEDOT:PSS, sur le substrat, par exemple oxyde conducteur transparent e.g. ITO, SnO₂:F, contenant l'OMNS d'oxyde de zinc avec les NPs Ensuite, on dépose une électrode métallique, par exemple or, argent, aluminium, par évaporation thermique sous vide à travers un masque. En enregistrant l'évolution du courant entre l'électrode métallique et le substrat en fonction de la tension appliquée dans le noir ou sous éclairage, il est possible d'observer un comportement photovoltaïque.

### Exemples dé réalisation

Exemple 1 : *Synthèse de l'agent de couplage acide mercaptoéthylphosphonique (MEPA)* Le protocole suit celui de la référence [Foster, E.W. ; Kearns, G.J. ; Goto, S. ; Hutchison, J.E. Adv. Mater. 2005, 17, 1542-1545]. Dans cette synthèse on prépare d'abord l'ester diéthylique de l'acide (2-tritylsulfanyléthyl)phosphonique en ajoutant de l'ester diéthylique de l'acide (2-bromoéthyl)phosphonique au triphénylméthanethiol déprotoné préalablement par l'hydrure de sodium (NaH). On enlève ensuite le groupement protecteur du produit de cette réaction par le triéthylsilane et l'hydrolyse acide chlorhydrique (HCl).

### Exemple 2 : Synthèse de l'agent de couplage acide mercaptoundécylphosphonique (MUPA)

Le protocole suit celui de la référence [Fiurasek, P.; Reven, L. Langmuir 2007, 23, 2857-66]. On synthétise d'abord diéthyl 10-undécylphosphonate à partir du 11-bromo-1-undécène. Il est condensé ensuite avec l'acide thioacétique pour donner 11-(acétylthio)undécylphosphate par une réaction radicalaire. On déprotège le groupe thiol par l'acide chlorhydrique (HCl) concentré suivi par l'hydrolyse acide de l'ester.

### Exemple 3 : Synthèse des nanocristaux CulnS₂

Le protocole suit celui de la référence [Panthani, M. G.; Akhavan, V.; Goodfellow, B.; Schmidtke, J. P.; Dunn, L.; Dodabalapur, A.; Barbara, P. F.; Korgel, B. A. J. Am. Chem. Soc. 2008, 2, 16770-16777]. 1 mmol d'acétylacétonate de Cuivre(II) (Cu(acac)₂) et 1 mmol d'In(acac)₃ sont ajoutés à 7 mL de dichlorobenzène (DCB) dans un ballon tricol de 25 mL. Dans un autre ballon tricol de 25 mL 2 mmol de soufre élémentaire sont dissouts dans 3 mL de DCB. Les deux ballons sont purgés d'oxygène et d'eau sous vide primaire à température ambiante pendant 30 min, suivi d'un bullage de N₂ à 60 °C pendant 30 min. 1 mL d'oléylamine est ajouté au mélange et les deux ballons sont chauffés à 110 °C et combinés sous flux de N₂. Le mélange est mis sous reflux (-182 °C) pour 1 h toujours sous N₂. La réaction est refroidie à température ambiante. Les nanocristaux sont séparés en ajoutant de l'éthanol en excès et en centrifugeant.

Des nanocristaux de la composition CulnS₂ et d'un diamètre de 15-20 nm sont obtenus. Ils sont solubles dans les solvants non-polaires et leur surface est couverte d'oléylamine.

### Exemple 4 : Fabrication de nanofils de ZnO

Les dépôts d'oxyde de zinc (ZnO) (couches 2D ou nanofils) sont préparés par électrodéposition sur un substrat de verre/SnO₂:F (10 Ω/sq). Les substrats sont nettoyés dans un bain à ultrasons, pendant 15 minutes dans du trichloréthylène, pendant 15 minutes dans l'acétone, pendant 15 minutes dans de l'isopropanol et rincés entre chaque étape par de l'eau chaude déionisée. Le dépôt est réalisé dans une cellule électrochimique à trois électrodes avec un fils de platine comme contrélectrode et une électrode de calomel saturée (ECS) comme électrode de référence. L'électrolyte est une solution aqueuse de 5mM de ZnCl₂ et 0.1M de KCl pour les couches 2D et 5.10⁻⁴ M de ZnCl₂ et 0.1 ou 1 M KCl pour les nanofils. Toutes les expériences sont réalisées avec des électrolytes saturées avant électrodéposition par de l'oxygène moléculaire pendant une heure sous fort bouillonnement. La température du bain est de 50 à 70°C pour les couches 2D et de 80° pour les nanofils. L'oxyde de Zinc est déposé potentiostatiquement à -1.0 V vs ECS. La densité de charge est fixée à 0.4 C/cm² pour les couches 2D de ZnO et 10 C/cm² pour les nanofils de ZnO. Le volume du bain est de 200 ml et la solution doit être changée après deux dépôts.

### Exemple 5 : Fonctionnalisation d'un substrat de ZnO par le MEPA ou le MUPA

Les substrats d'oxyde de zinc (ZnO) (couches 2D ou nanofils) sont nettoyés par rinçage avec de l'eau suivi par de l'éthanol (EtOH). Ensuite ils sont séchés sous argon (Ar) et exposés aux UV sous ozone (O₃) pendant 10 min. Immédiatement après ils sont trempés dans les solutions 1 mM des acides MEPA ou MUPA dans de l'éthanol pendant 1 h. A la fin de trempage, les substrats sont rincés à nouveau avec de l'éthanol frais et séchés sous argon.

### Exemple 6 : Dépôt de NPs sur le substrat de ZnO fonctionnalisé

Les substrats d'oxyde de zinc (ZnO) fonctionnalisés sont immergés dans la solution concentrée de NPs de CulnS₂ dans du chloroforme pendant 12h. Ensuite ils sont rincés avec de chloroforme frais et séchés sous argon.

### Exemple 7 : Fabrication d'une cellule solaire

Sur un substrat verre/SnO₂:F contenant les nanofils de ZnO fonctionnalisés avec 3 couches de nanoparticules de CulnS₂ en utilisant l'agent de couplage MUPA pour la première couche puis l'EDT pour les couches suivantes 100 µL d'une solution saturé de CuSCN dans di-n-propylsulfure sont étalés de manière homogène en chauffant le substrat à 90°C. Dans la suite une couche de 100 nm épaisseur d'or est déposée sous vide à travers un masque. Puis les caractéristiques de la cellule solaire sont enregistrées en mesurant l'évolution du courant entre l'électrode d'or et le substrat de ZnO en fonction de la tension appliquée dans le noir ou sous éclairage

Les caractéristiques des exemples ci-dessus peuvent être prises seules ou combinées entre elles sans préjudice pour la portée de la protection.

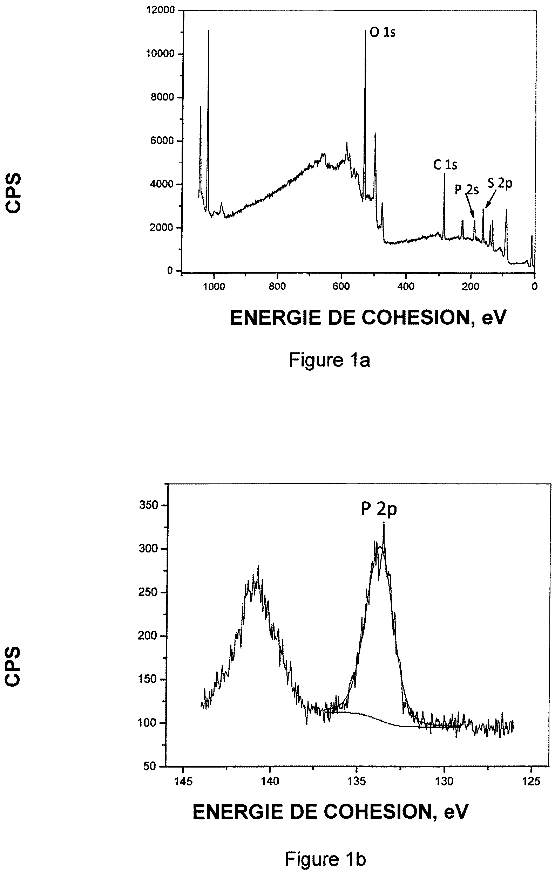

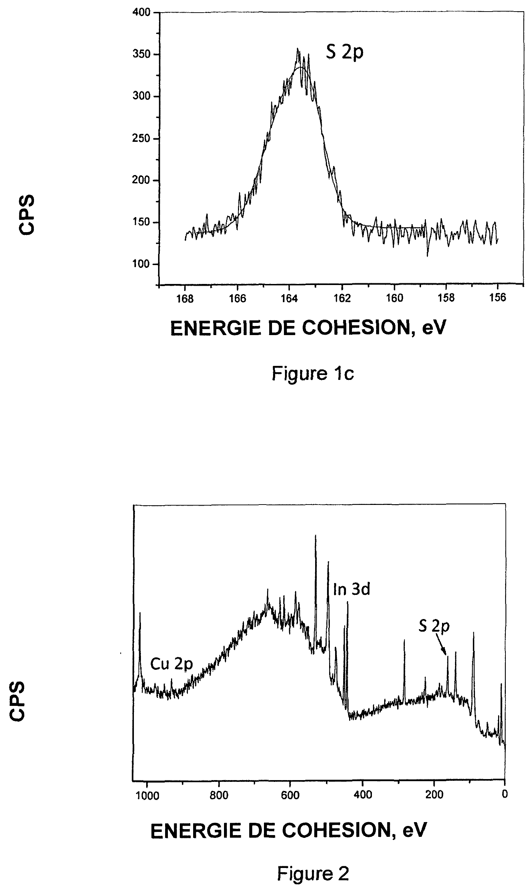

Selon l'invention, l'utilisation de la spectrométrie photoélectronique X ou XPS (en anglais : *X-Ray photoelectron spectroscopy*) permet de confirmer la réalisation de l'étape de fonctionnalisation de la surface d'OMNS par l'agent de couplage (fig. 1) ainsi que le greffage des NPs (figure 2).

### Description des figures.

En figure 1a, un spectre de spectrométrie photoélectronique X des nanofils d'oxyde de zinc (ZnO) avec de l'acide mercaptoéthylphosphonique (MEPA) permet de confirmer la présence du MEPA sur l'OMNS par l'identification de pics (P et S) correspondant aux composants caractéristiques de l'OMNS et du MEPA.
Les figures 1b et 1c montrent des résultats des mesures en spectroscopie de photoélectrons X. Dans les spectres haute résolution on distincte les pics correspondant aux atomes de phosphore et de soufre caractéristiques du MEPA
La figure 2 représente un spectre de spectroscopie photoélectronique X des nanofils d'oxyde de zinc (ZnO) fonctionnalisé avec du MEPA et greffés avec des nanocristaux de CulnS₂. La présence des pics de Cu (Cu2p), In (In3d) et S (S2p) correspondant aux composants de l'empilage confirme le dépôt des nanocristaux
Le tableau ci-après donne les angles de contact obtenus en mesurant les angles des gouttes d'eau déposées sur une surface plane d'oxyde de zinc (ZnO) fonctionnalisée avec du MEPA et avec du MUPA. L'augmentation de l'angle est due au caractère plus hydrophobe des surfaces fonctionnalisées ce qui confirme la présence de l'agent de couplage.

| | ZnO | ZnO/MEPA | ZnO/MUPA |
|---|---|---|---|
| Angle de contact | 55° | 75° | 72° |

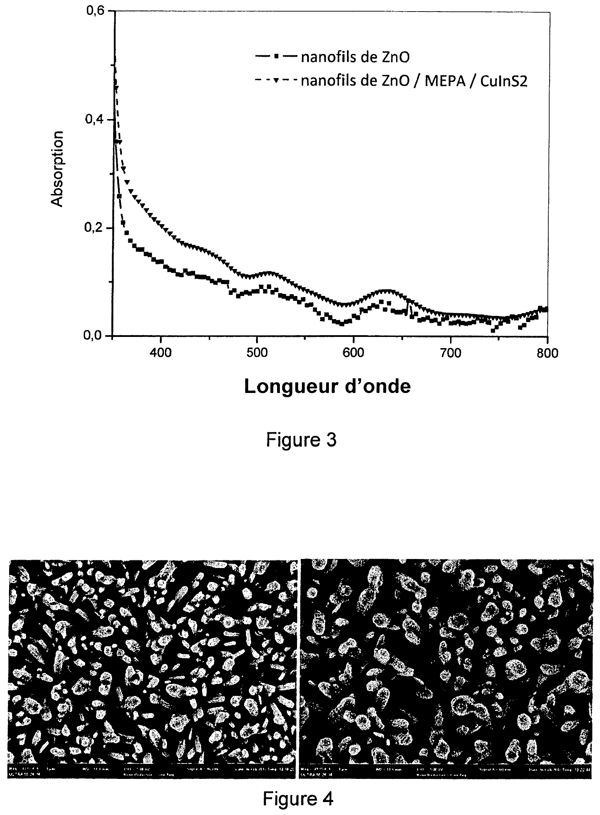

La figure 3 montre les spectres d'absorption UV visible enregistrés pour un substrat de nanofils de ZnO avant et après la fonctionnalisation de l'OMNS et le greffage de NCx de CulnS₂. L'augmentation de l'absorption observée pour des longueurs d'onde supérieures à 375 nm confirme la présence de NCx absorbants.
En figure 4, des images de microscopie électronique à balayage (MEB) enregistrés pour un substrat de nanofils de ZnO avec les NCx de CulnS₂ déposés sans (à gauche) et avec (à droite) la fonctionnalisation de l'OMNS par l'agent de couplage MUPA. Les images confirment la présence des nanocristaux sur le ZnO. Le dépôt beaucoup plus homogène sur le ZnO fonctionnalisé confirme l'importance de l'utilisation du MUPA.

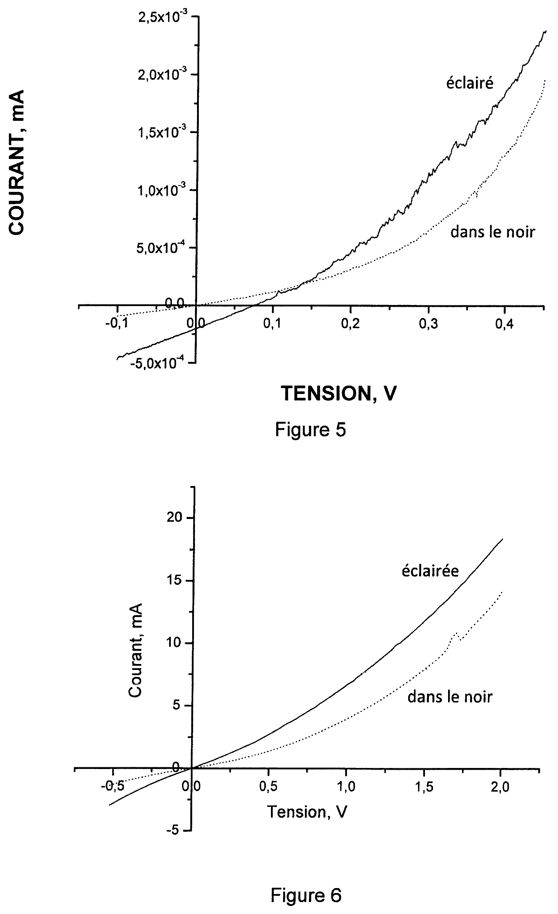

La figure 5 donne les caractéristiques courant-tension pour une cellule à base de nanofils ZnO/MUPA/CulnS2/spiro-OMeTAD/Au dans le noir et sous éclairement. Les courbes montrent un effet photovoltaïque du fait du photo-courant mesuré à V=0 sous éclairage avec 1000 W/m².
La figure 6 donne les caractéristiques courant-tension pour une cellule à base de nanofils ZnO/spiro-OMeTAD/Au, i.e. sans utilisation des nanocristaux, dans le noir et sous éclairement. L'absence de photo-courant à V = 0 sous éclairage montre qu'il n'y a pas d'effet photovoltaïque dans ce cas.

## Revendications

1. Procédé de dépôt de nanoparticules (NPs) sur un substrat d'oxyde métallique nanostructuré (OMNS) d'oxyde de zinc, comprenant des étapes de :
a) fonctionnalisation du substrat d'OMNS par un agent de couplage bi-fonctionnel portant une première fonction formant une liaison avec l'OMNS, et une deuxième fonction destinée à former une liaison avec une nanoparticule ; et
b) greffage des nanoparticules par une liaison à la deuxième fonction de l'agent de couplage,
**caractérisé par le fait que** l'on utilise comme première fonction une fonction phosphonique.

2. Procédé selon la revendication 1 dans lequel les étapes a) et b) sont effectuées par voie humide.

3. Procédé selon l'une quelconque des revendications précédentes dans lequel les NPs sont synthétisés de manière indépendante

4. Procédé selon l'une quelconque des revendications précédentes dans lequel l'étape a) comprend le trempage de l'OMNS dans une solution d'agent de couplage bifonctionnel.

5. Procédé selon la revendication précédente dans lequel le trempage de l'OMNS dure 1 minute à 6 heures.

6. Procédé selon l'une quelconque des deux revendications précédentes dans lequel le trempage est précédé et suivi d'un rinçage avec un solvant et d'un séchage.

7. Procédé selon l'une quelconque des revendications précédentes dans lequel l'étape b) comprend un trempage de l'OMNS fonctionnalisé obtenu à l'issue de l'étape a) dans une solution de nanoparticules.

8. Procédé selon la revendication précédente dans lequel le trempage de l'OMNS fonctionnalisé dure de 1 à 72 heures.

9. Procédé selon l'une quelconque des deux revendications précédentes dans lequel le trempage de l'OMNS fonctionnalisé est suivi d'un rinçage avec un solvant et d'un séchage.

10. Procédé selon l'une quelconque des revendications précédentes dans lequel les étapes a) et b) sont effectuées à température comprise entre 10°C et 80°C.

11. Procédé selon l'une quelconque des revendications précédentes dans lequel à l'étape a), l'agent de couplage bifonctionnel est en solution dans l'éthanol ou du diméthylsulfoxyde ou de l'eau.

12. Procédé selon l'une quelconque des revendications précédentes dans lequel à l'étape b) les NPs sont en solution dans du chloroforme, du toluène, de l'hexane ou de l'heptane.

13. Procédé selon l'une quelconque des revendications précédentes dans lequel l'agent de couplage comprend un espaceur entre la première fonction et la deuxième fonction.

14. Procédé selon la revendication précédente dans lequel l'espaceur comprend une chaîne carbonée de nature aliphatique saturée ou insaturée, linéaire ou ramifiée, ou de nature aromatique comportant de 2 à 36 atomes de carbone.

15. Procédé selon l'une quelconque des revendications précédentes dans lequel l'agent de couplage est choisi parmi l'acide mercaptoéthylphosphonique (MEPA) et l'acide mercaptoundécylphosphonique (MUPA).

16. Procédé selon l'une quelconque des revendications précédentes dans lequel les nanoparticules sont des systèmes binaires, ternaires ou multinaires.

17. Procédé selon l'une quelconque des revendications précédentes dans lequel les nanoparticules sont de type coeur/coquille.

18. Procédé selon l'une quelconque des revendications précédentes dans lequel la deuxième fonction est choisie parmi une fonction acide phosphinique, acide phosphonique, phosphine, oxyde de phosphine, acide carboxylique, amine, imidazole, pyridine, thiol, dithiol, carbodithioate, dithiocarbamate, xanthate, sulfonate, sulfate, sélénoate ou sélénate.

19. Procédé selon l'une quelconque des revendications précédentes comprenant postérieurement à l'étape b) les étapes successives de :
- fonctionnalisation des NPs greffées à l'OMNS, par un deuxième agent de couplage bi-fonctionnel, configurés pour former une liaison avec les NPs liées à l'OMNS ; et
- greffage des NPs par une liaison au deuxième agent de couplage.

## Patentansprüche

1. Verfahren zur Abscheidung von Nanoteilchen (NPs) auf einem nanostrukturierten Metalloxid-Substrat (NSMO) aus Zinkoxid, umfassend die Schritte:
a) Funktionalisieren des NSMO-Substrats mit einem bifunktionellen Kopplungsmittel, das eine erste Funktion aufweist, die eine Bindung mit dem NSMO bildet, und eine zweite Funktion, die dazu bestimmt ist, eine Bindung mit einem Nanoteilchen zu bilden; und
b) Aufpropfen von Nanoteilchen durch eine Bindung mit der zweiten Funktion des Kopplungsmittels,
**dadurch gekennzeichnet, dass** als erste Funktion eine Phosphon-Funktion verwendet wird.

2. Verfahren nach Anspruch 1, wobei die Schritte a) und b) nass durchgeführt werden.

3. Verfahren nach einem der vorhergehenden Ansprüche, wobei die NPs unabhängig synthetisiert werden.

4. Verfahren nach einem der vorhergehenden Ansprüche, wobei Schritt a) das Eintauchen von NSMO in einer Lösung des bifunktionellen Kopplungsmittels umfasst.

5. Verfahren nach dem vorhergehenden Anspruch, wobei das Eintauchen von NSMO 1 Minute bis 6 Stunden dauert.

6. Verfahren nach einem der beiden vorhergehenden Ansprüche, wobei dem Eintauchen ein Spülen mit einem Lösungsmittel und eine Trocknung vorausgehen oder folgen.

7. Verfahren nach einem der vorhergehenden Ansprüche, wobei Schritt b) ein Eintauchen von funktionalisiertem NSMO, das nach Schritt a) erhalten wird, in einer Lösung von Nanoteilchen umfasst.

8. Verfahren nach dem vorhergehenden Anspruch, wobei das Eintauchen von funktionalisiertem NSMO 1 bis 72 Stunden dauert.

9. Verfahren nach einem der beiden vorhergehenden Ansprüche, wobei das Eintauchen von funktionalisiertem NSMO von einem Spülen mit einem Lösungsmittel und einer Trocknung gefolgt wird.

10. Verfahren nach einem der vorhergehenden Ansprüche, wobei die Schritte a) und b) bei einer Temperatur zwischen 10 °C und 80 °C durchgeführt werden.

11. Verfahren nach einem der vorhergehenden Ansprüche, wobei in Schritt a) das bifunktionelle Kopplungsmittel in Lösung in Ethanol oder Dimethylsulfoxid oder Wasser ist.

12. Verfahren nach einem der vorhergehenden Ansprüche, wobei in Schritt b) die NPs in Lösung in Chloroform, Toluol, Hexan oder Heptan sind.

13. Verfahren nach einem der vorhergehenden Ansprüche, wobei das Kopplungsmittel einen Abstandhalter zwischen der ersten Funktion und der zweiten Funktion umfasst.

14. Verfahren nach dem vorhergehenden Anspruch, wobei der Abstandhalter eine Kohlenstoffkette vom gesättigten oder ungesättigten aliphatischen, linearen oder verzweigten Typ oder aromatischen Typ mit 2 bis 36 Kohlenstoffatomen umfasst.

15. Verfahren nach einem der vorhergehenden Ansprüche, wobei das Kopplungsmittel aus Mercaptoethylphosphonsäure (MEPA) und Mercaptoundecylphosphonsäure (MUPA) ausgewählt wird.

16. Verfahren nach einem der vorhergehenden Ansprüche, wobei die Nanoteilchen binäre, ternäre oder multinäre Systeme sind.

17. Verfahren nach einem der vorhergehenden Ansprüche, wobei die Nanoteilchen vom Kern/Schalen-Typ sind.

18. Verfahren nach einem der vorhergehenden Ansprüche, wobei die zweite Funktion ausgewählt wird aus einer Phosphinsäure-, Phosphonsäure-, Phosphin-, Phosphinoxid-, Carbonsäure-, Amin-, Imidazol-, Pyridin-, Thiol-, Dithiol-, Carbodithioat-, Dithiocarbamat-, Xanthat-, Sulfonat-, Sulfat-, Selenoat- oder Selenat-Funktion.

19. Verfahren nach einem der vorhergehenden Ansprüche, welches nach Schritt b) die aufeinanderfolgenden Schritte umfasst:
- Funktionalisieren von auf NSMO aufgepropften NPs durch ein zweites bifunktionelles Kopplungsmittel, die ausgelegt sind, eine Bindung mit den an NSMO gebundenen NPs zu bilden; und
- Aufpfropfen der NPs durch eine Bindung mit dem zweiten Kopplungsmittel.

## Claims

1. Method for deposition of nanoparticles (NPs) on a nanostructured metal-oxide (NSMO) substrate of zinc oxide, comprising steps of:
a) functionalization of the NSMO substrate by a bifunctional coupling agent having a first function forming a bond with the NSMO, and a second function designed to form a bond with a nanoparticle; and
b) grafting of the nanoparticles by a bond to the second function of the coupling agent,
**characterized in that** a phosphonic function is used as the first function.

2. Method according to claim 1, in which steps a) and b) are carried out wet.

3. Method according to any one of the preceding claims, in which the NPs are synthesized independently.

4. Method according to any one of the preceding claims, in which step a) comprises the soaking of the NSMO in a solution of bifunctional coupling agent.

5. Method according to the preceding claim, in which the soaking of the NSMO takes from 1 minute to 6 hours.

6. Method according to any one of the preceding claims, in which the soaking is preceded and followed by rinsing with a solvent and drying.

7. Method according to any one of the preceding claims, in which step b) comprises the soaking of the functionalized NSMO obtained at the end of step a) in a solution of nanoparticles.

8. Method according to the preceding claim, in which the soaking of the functionalized NSMO takes from 1 to 72 hours.

9. Method according to any one of the preceding two claims, in which the soaking of the functionalized NSMO is following by rinsing with a solvent and drying.

10. Method according to any one of the preceding claims, in which steps a) and b) are carried out at a temperature of between 10°C and 80°C.

11. Method according to any one of the preceding claims, in which in step a) the bifunctional coupling agent is in solution in ethanol or dimethyl sulfoxide or water.

12. Method according to any one of the preceding claims, in which in step b) the NPs are in solution in chloroform, toluene, hexane or heptane.

13. Method according to any one of the preceding claims, in which the coupling agent comprises a spacer between the first function and the second function.

14. Method according to the preceding claim, in which the spacer comprises a carbon chain of linear or branched, saturated or unsaturated aliphatic nature, or of aromatic nature comprising from 2 to 36 atoms of carbon.

15. Method according to any one of the preceding claims, in which the coupling agent is chosen from mercaptoethylphosphonic acid (MEPA) and mercaptoundecylphosphonic acid (MUPA).

16. Method according to any one of the preceding claims, in which the nanoparticles are binary, ternary or multinary systems.

17. Method according to any one of the preceding claims, in which the nanoparticles are of heart/shell type.

18. Method according to any one of the preceding claims, in which the second function is chosen from a phosphinic acid, phosphonic acid, phosphine, phosphine oxide, carboxylic acid, amine, imidazole, pyridine, thiol, dithiol, carbodithioate, dithiocarbamate, xanthate, sulfonate, sulfate, selenoate or selenate function.

19. Method according to any one of the preceding claims, comprising after step b) the successive steps of:
- functionalization of the NPs grafted to the NSMO by a second bifunctional coupling agent, configured to form a bond with the NPs bonded to the NSMO; and
- grafting of the NPs by a bond to the second coupling agent.
